# EUROPEAN PATENT APPLICATION

(11) **EP 0 905 901 A1**
(43) Date of publication of application: **31.03.1999**
(21) Application number: 98203242.7
(22) Date of filing: 28.09.1998
(51) Int. Cl.: H03K 17/94

(54) **Safety switch**

(30) Priority: 26.09.1997 NL 1007130
(71) Applicant: THYSSEN DE REUS B.V., 2921 LN Krimpen a/d IJssel (NL)
(72) Inventor: Kasbergen, Paulus, 2906 CM Capelle aan den IJssel (NL)
(74) Representative: Smulders, Theodorus A.H.J., Ir.

(57) **Abstract**

The present invention relates to a safety circuit (1) which comprises an opto-switch (10). The opto-switch (10) has a light detector (12) and a light source (11) which is driven with an alternating voltage signal (L). An output signal (D) of the safety circuit (1) is an alternating voltage signal if the circuit functions correctly and an optical path (14) between the light source (11) and the light detector (12) is clear. If the safety circuit (1) is defective, the output signal (D) of the safety circuit (1) is a direct voltage signal.

## Description

The present invention generally relates to a safety switch.

In the art, many types of detectors are known which can provide an electrical signal that is indicative of the occurrence or non-occurrence of a certain condition. Mentioned here by way of example is a door closing switch, i.e., a switch which is operated by a door and which has two switch states: a first switch state is indicative of the open condition of the door, and a second switch state is indicative of the closed condition of the door. Conventionally, such a switch is an electro-mechanical switch with two terminals, and the switch states referred to are defined by the current path between these terminals being closed or not.

Also known are so-called opto-switches. Generally, such switches comprise a light source and a light detector, and the light detector provides an electrical signal that is indicative of whether or not the light emitted by the light source is being received. Further provided is a light path interrupter which can be moved into the light path between the light source and the light detector. Such an opto-switch, too, is an ON/OFF switch, where the two switch states are defined by whether or not the light path is interrupted by the light path interrupter.

Known detectors and switches have the problem that failure of the switch results in the occurrence of either of the switch states referred to. The presence of dirt between switch contacts, or in the light path, or the occurrence of a broken electrical conductor, cause a current path between the terminals to be continuously interrupted. If a closing contact is stuck, or a short-circuit occurs, this will cause a current path between the terminals to be continuously closed. In such a case, the state of the switch, and hence the signal delivered by the switch, is no longer indicative of the condition to be monitored. In the above-mentioned example of a door closing switch, it can then no longer be derived from the output signal of the switch if the door in question is open or closed.

In known safety circuits, failure of the switch or detector is not investigated. Known safety circuits are therefore not completely reliable. This means that dangerous situations might arise in practice. By way of example, a lift is mentioned here. A lift cabin should obviously not move until the lift door is closed; a lift door may only be opened if the lift cabin is in the correct position opposite the door. For these reasons, a lift is fitted with various safety switches, for instance on the doors, which check if the doors are closed.

The above-mentioned possibility of failure of a switch is a problem that plays a role in particular in situations where safety is at stake. Conventionally, a solution to this problem is sought in the sphere of construction: as a safety switch, a mechanical switch is used in which not only the potentially dangerous situation (door open; reaching the end position) corresponds with the open position of the switch (current path between terminals interrupted), but in which, further, the construction is such that if the potentially dangerous situation in question arises, the current path of the switch is forced to open, either "normally" (break contacts are broken) or by force (switch is destroyed).

A disadvantage of such mechanical safety switches is that they require a good deal of space, and that the correct operation of the switch contacts is affected by dust, dirt and oxide. Accordingly, there is a need for a simple safety circuit of smaller size and of improved reliability, in particular one without contacts sensitive to dirt and oxide.

It is therefore an object of the present invention to provide a safety switch which, when the switch functions correctly generates in at least one switch state a signal indicative of the correct functioning of the switch.

According to an important aspect of the present invention, a safety circuit comprises an opto-switch whose light source is supplied with a modulated signal. When the switch functions correctly, this circuit provides a modulated signal at its output if the light path is uninterrupted. A failure of the switch results in either a continuous LOW or a continuous HIGH signal at the output.

These and other aspects, features and advantages of the present invention will be clarified by the following description of an embodiment of a safety circuit according to the invention, with reference to the drawings, wherein:
Fig. 1 is a block diagram of a safety circuit; and
Figs. 2A-D illustrate electrical signals.

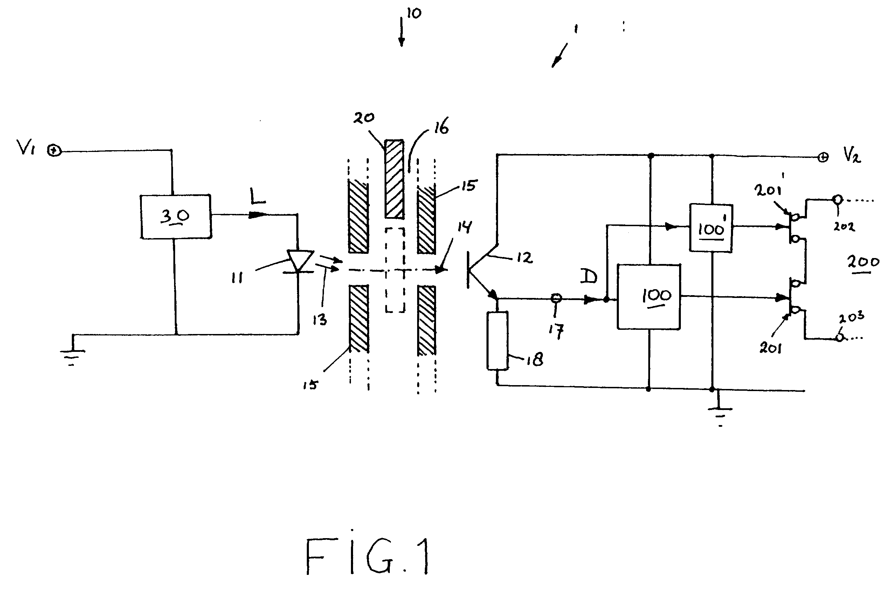

In Fig. 1, a safety switch according to the present invention is designated by reference numeral 1. The safety switch 1 comprises an opto-switch, generally indicated by the reference numeral 10, which comprises a light source 11 and a light detector 12. The light source 11 is represented as a LED, and the light detector 12 is represented as a light-sensitive transistor, but that is not essential. The light source 11 generates light 13, which can reach the light detector 12 via a light path 14. The opto-switch 10 comprises screening means 15 for screening from ambient light, which screening means 15 leave the light path 14 clear. The screening means 15 further leave an interrupter path 16 clear, along which a light interrupter 20 can be displaced between an interrupt position, in which the light interrupter 20 interrupts the light path 14, and a pass position, in which the light interrupter 20 leaves the light path 14 clear, so that the light 13 is allowed to pass. In Fig. 1, the light interrupter 20 is represented in the pass position; the interrupt position is indicated in dotted lines.

The opto-switch 10 has an output 17, being also the output of the safety switch 1, where an output signal D is provided which, if the safety switch 1 functions correctly, is indicative of whether or not the light path 14 is interrupted by the light interrupter 20. That output signal D functions as input signal for a control element 100, which makes decisions based on the signal D.

The light interrupter 20 will not be further described here, since its nature and construction do not constitute a subject of the present invention. Suffice it to note that the use of a light interrupter in an opto-switch is known per se. In one possible exemplary application, the light interrupter 20 is operated by a lift door, and the control element 100 is arranged for controlling the drive of a lift cabin.

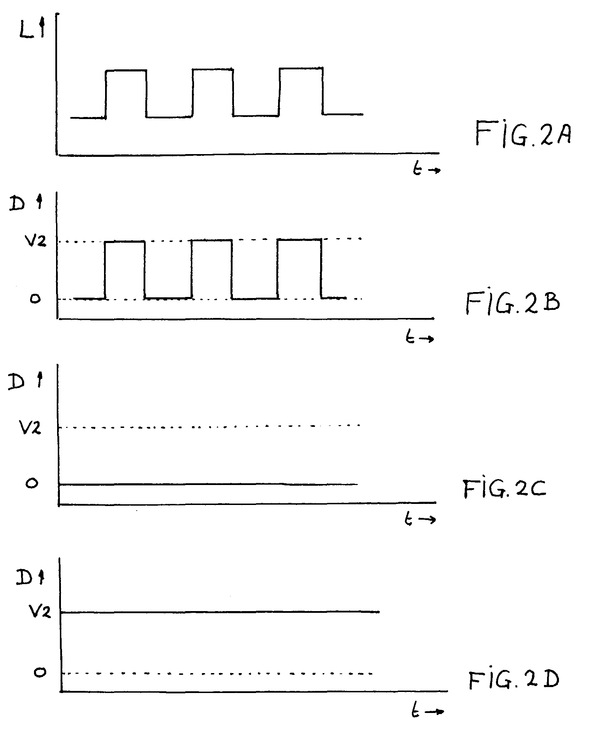

The safety switch 1 further comprises a signal source 30 which provides a control signal L by which the light source 11 is driven. According to an important aspect of the present invention, the control signal L is a modulated signal, at least, the control signal L has a modulation component. The control signal L may be an alternating voltage signal, at least, may have an alternating component. In a preferred embodiment, the control signal L is a square-wave signal, as illustrated in Fig. 2A. A suitable frequency of the control signal L is in the range of 250 to 2500 Hz. The light 13 generated by the light source 11 will fluctuate in strength in accordance with the fluctuations of the control signal L.

The signal source 30 will not be further described here, since its nature and construction do not constitute a subject of the present invention. Suffice it to note that signal sources capable of generating a modulated signal suitable to drive the light source 11 will be known to those skilled in the art.

When the safety switch 1 functions correctly, then, in the case where the light interrupter 20 is in the pass position so that the light path 14 is clear, the light detector 12 will generate an output signal D that fluctuates in accordance with the light strength fluctuations of the light 13. In the exemplary embodiment represented, the light detector 12 is designed as a light-sensitive NPN-transistor, whose collector is connected to a positive direct voltage V2, and whose emitter, connected to the output terminal 17, is connected to mass via a resistor 18. During a part of the cycle of the control signal L where the control signal L is minimal, the light intensity of the light 13 is zero, at least relatively low, and the transistor 12 will conduct weakly, if at all, so that the instantaneous value of the output signal D is substantially equal to zero. During a part of the cycle of the control signal L where the control signal L is maximal, the light intensity of the light 13 is maximal, and the transistor 12 will conduct relatively strongly, so that the instantaneous value of the output signal D is substantially equal to V2. Thus, this condition is characterized in that the output signal D at output 17 is a modulated signal, at least has a varying level, as illustrated in Fig. 2B.

When the safety switch 1 functions correctly, then, in the case where the light path 14 is interrupted by the interrupter 20, the light detector 12 will generate an output signal D having a constant voltage level. In the exemplary embodiment represented, the transistor 12 will then conduct weakly, if at all, so that the value of the output signal D then substantially equals zero. Thus, this condition is characterized in that the output signal D at output 17 is a direct voltage signal having the value zero (LOW), as illustrated in Fig. 2C.

In case of failure of the safety switch 1, the output signal D will either be continuously LOW (Fig. 2C) or continuously HIGH (Fig. 2D). The cause of the first-mentioned situation may be that the light source 11 is defective and generates no light 13; that the signal source 30 is defective and generates no control signal L; that the transistor 12 is defective and represents an open connection; or that the emitter of the transistor is short-circuited to mass. The cause of the second situation may be that the signal source 30 is defective and generates a continuous HIGH control signal L; or that the emitter of the transistor is short-circuited to V2. In exceptional cases, the output 17 may be floating, for instance if both the resistor 18 and the transistor 12 are defective and represent an open connection.

The control element 100 is arranged to monitor the signal D continuously, and to examine if that signal is indicative of one of the following three switch conditions: varying voltage level, continuous HIGH, or continuous LOW. If the signal D is a continuous HIGH, the control element 100 "knows" with certainty that the circuit 1 is defective; the control element 100 can then optionally generate an alarm signal to alarm a repairer. If the signal D is a modulated signal, the control element 100 "knows" with certainty that the circuit 1 functions correctly; this switch condition may therefore be qualified as SAFE. If the signal D is a continuous LOW, this signal may have been caused by a defective circuit 1, but also by the light interrupter 20; the control element 100 has no possibility of discriminating between these causes; this switch condition may therefore be qualified as UNSAFE.

Thus, the present invention makes it possible, simply by examining the output signal D of the safety switch 1, to monitor simultaneously the switching of the opto-switch 10 and whether or not the safety switch 1 is defective.

Depending on the application, the SAFE switch condition will be associated with allowing a potentially dangerous situation. For instance, in the above-mentioned exemplary use in a lift door, the light interrupter 20 will clear the light path 14 only if the lift cabin is in the correct position, which is indicated by a modulated signal D; the control element 100 is arranged then to release the opening mechanism of the lift door if the signal D is a modulated signal. In Fig. 1, such an opening mechanism is generally designated by the reference numeral 200. An exciting circuit for an electric motor of that opening mechanism 200 includes an electrically operable control switch 201, for instance a relay, which is normally in the open condition. The control switch 201 is operated by the control element 100. Only when the signal D is a suitable modulated signal will the control element 100 control the control switch 201 to the closed condition. The control element 100 is arranged to keep the door closed in all other cases, that is, when the signal D is a direct voltage signal, which is to say, in the illustrated example, that the control switch 201 is opened or remains open.

The present invention also provides for the possibility of the control element 100 becoming defective, such that the control element 100 wrongly closes the control switch 201, whereby the opening mechanism 200 of the door might be wrongly excited. To reduce these risks, a second control element 100' is provided, which is connected in parallel with the first control element 100. The second control element 100' also receives the signal D, and is arranged to make the same decisions as the first control element 100; in principle, the second control element 100' can be identical to the first control element 100, but it is preferred that the two control elements are of different types. Both control elements can, for instance, block the opening mechanism 200 of the door autonomously and completely independently of each other, and, as illustrated, in that the second control element 100' actuates a second control switch 201', which is connected in series with the first control switch 201.

The signal source 30 can be supplied with a direct voltage V1, and the light detector 12 can be supplied with a direct voltage V2. The direct voltages V1 and V2 can be derived from a common alternating voltage source, for instance the mains. Preferably, the direct voltages V1 and V2 are galvanically separated from each other.

It will be clear to those skilled in the art that the scope of protection of the present invention as defined by the claims is not limited to the embodiment represented in the drawings and discussed, but that it is possible to alter or modify the represented embodiment of the safety switch according to the invention within the scope of the inventive concept. Thus, for instance, it is possible that the level of the output signal D is HIGH if the detector 12 receives no light, and LOW if the detector 12 does receive light. Further, it is possible that the signal source 30 is not part of the safety switch itself but that the light source 11 is driven by the control element 100, in other words, that the signal source 30 is incorporated into the control element 100.

Further, it is not necessary per se that the light signal 13 has such intensity fluctuations that the signal D is driven to full output between V2 and 0. It is sufficient if the light signal 13 induces into the signal D a modulated component of a sufficiently high amplitude.

Further, it is not necessary that the light 13 is generated by a light source which is driven by a control signal generator 30. It is also possible that a light source that generates light of varying intensity is realized in a different manner, for instance by connecting a repeat interrupter in series with a supply line of the light source.

The light signal 13 and the varying component thereby induced into the signal D can be sine-shaped or block-shaped signals. It is also possible that the light signal is a coded pulse-shaped signal, the pulse code being known to the control element 100, in which case the control element 100 not only examines the variation of the intensity of the signal D but also examines the code contained in that signal D and compares it with the priorly known code.

Further, if desired, it is possible to connect a plurality of control switches in series, which are operated by respective control elements connected in parallel.

Preferably, the two control switches 201 and 201' are part of the safety circuit, and are mounted, along with the safety switch 10 and the two control elements 100 and 100', on a single printed-circuit board, so that the terminals 202 and 203 indicated in Fig. 1 form the output terminals of the safety circuit.

## Claims

1. A safety switch (1), comprising:
- a light source (11) for generating light (13) of varying intensity;
- a light detector (12) for receiving the light (13) generated by the light source (11) and generating an electrical signal (D) whose strength is representative of the strength of the light (13) received by the detector (12);
- a displaceable light interrupter (20) which is displaceable between an interrupt position, in which the light interrupter (20) interrupts a light path (14) between the light source (11) and the light detector (12), and a pass position, in which the light interrupter (20) leaves the light path (14) clear.

2. A safety switch according to claim 1, wherein a control element (100) is arranged to monitor the electrical signal (D) and, if the signal (D) is a modulated signal, to allow a potentially dangerous situation such as the opening of a lift door, and, if the signal (D) is a direct voltage signal, to prevent said potentially dangerous situation such as the opening of a lift door.

3. A safety switch according to claim 2, wherein the control element (100) is arranged to close a control switch (201) if the signal (D) is a modulated signal.

4. A safety switch according to claim 2 or 3, comprising a second control element (100') which is likewise arranged to monitor the signal (D) and, if the signal (D) is a modulated signal, to allow a potentially dangerous situation such as the opening of a lift door, and, if the signal (D) is a direct voltage signal, to prevent said potentially dangerous situation such as the opening of a lift door.

5. A safety switch according to claim 4, wherein the second control element (100') is arranged to close a second control switch (201') if the signal (D) is a modulated signal, which second control switch (201') is connected in series with the first control switch (201).
